# EUROPÄISCHE PATENTSCHRIFT

(11) **EP 1 153 442 B1**
(45) Veröffentlichungstag und Bekanntmachung des Hinweises auf die Patenterteilung: **07.01.2015**
(21) Anmeldenummer: 00907442.8
(22) Anmeldetag: 25.01.2000
(51) Int. Cl.: H01L 33/00

(54) **HALBLEITERBAUELEMENT ZUR ERZEUGUNG VON MISCHFARBIGER ELEKTROMAGNETISCHER STRAHLUNG**
SEMICONDUCTOR COMPONENT FOR GENERATING MIXED-COLOR ELECTROMAGNETIC RADIATION
COMPOSANT A SEMI-CONDUCTEUR UTILISE POUR LA PRODUCTION D'UN RAYONNEMENT ELECTROMAGNETIQUE A COULEURS MELANGEES

(30) Priorität: 25.01.1999 DE 19902750
(43) Veröffentlichungstag der Anmeldung: 14.11.2001
(73) Patentinhaber: OSRAM Opto Semiconductors GmbH, 93055 Regensburg (DE)
(72) Erfinder: HOMMEL, Detlef, D-28309 Bremen (DE); WENISCH, Helmut, Sagamihara Shi 228-0803, (JP)
(74) Vertreter: Epping - Hermann - Fischer
(86) Internationale Anmeldenummer: PCT/DE2000/000201
(87) Internationale Veröffentlichungsnummer: WO 2000/044053

(56) Entgegenhaltungen:
- EP-A- 0 486 052
- EP-A- 0 971 421
- EP-A- 0 977 278
- US-A- 4 570 172
- PATENT ABSTRACTS OF JAPAN vol. 1998, no. 14, 31. Dezember 1998 (1998-12-31) -& JP 10 261818 A (FUJITSU LTD), 29. September 1998 (1998-09-29)
- PATENT ABSTRACTS OF JAPAN vol. 1998, no. 06, 30. April 1998 (1998-04-30) -& JP 10 056203 A (NIPPON SANSO KK), 24. Februar 1998 (1998-02-24)
- PATENT ABSTRACTS OF JAPAN vol. 2000, no. 01, 31. Januar 2000 (2000-01-31) & JP 11 274558 A (TOSHIBA CORP), 8. Oktober 1999 (1999-10-08)

## Beschreibung

Die Erfindung betrifft ein Halbleiterbauelement zur Erzeugung von mischfarbiger elektromagnetischer Strahlung, insbesondere von weißem Licht, das einen Halbleiterchip mit einer ersten Halbleiterschicht und einer benachbart zu dieser angeordneten zweiten Halbleiterschicht mit einem elektrolumineszierenden Bereich aufweist.

Weißes Licht wird heutzutage hauptsächlich mit Glühlampen oder Leuchtstoffröhren erzeugt, die Licht mit einem breiten Wellenlängenspektrum abgeben.

Lichtemittierende Halbleiterbauelemente, wie Lumineszenzdioden (LEDs) oder Halbleiterlaserdioden, haben hingegen ein Emissionsspektrum, das typischerweise nur 10 bis 25 nm breit ist, d. h. sie sind nahezu monochromatisch. Sie haben aber den besonderen Vorteil, daß sie nur einen Bruchteil des Stromes benötigen, den eine Glühlampe oder eine Leuchtstoffröhre benötigt. Zudem ist ihre Lebensdauer deutlich größer als die von Glühlampen oder Leuchtstoffröhren. Wenn ein großflächiger Emitter notwendig ist, können LEDs oder Laserdioden auf einfache Weise zu Arrays zusammengeschaltet werden.

Mit LEDs der drei Grundfarben rot, grün und blau oder der zwei Komplementärfarben blau und gelb läßt sich durch additive Farbmischung Licht erzeugen, das für das menschliche Auge weiß erscheint. Besondere Nachteile sind hierbei aber, daß drei bzw. zwei Lumineszenzdioden einzeln elektrisch angesteuert werden müssen, wodurch aufwendige Ansteuerelektroniken (verschiedenartige LEDs benötigen in der Regel unterschiedliche Ansteuerspannungen) notwendig sind, daß ein hoher Montageaufwand erforderlich ist und daß die Bauteil-Miniaturisierung stark begrenzt ist.

In der EP-A-0 486 052 wird ein Halbleiterbauelement beschrieben, das einen Halbleiterchip mit einer ersten Halbleiterschicht und einer benachbart zu dieser angeordneten zweiten Halbleiterschicht aufweist, die auf einem Substrat aufgebracht ist, wobei die erste Halbleiterschicht zwischen dem Substrat und der zweiten Halbleiterschicht angeordnet ist,
die zweite Halbleiterschicht einen elektrolumineszierenden Bereich enthält, der Licht mit einer Wellenlänge λ_{E} aussendet, und
die erste Halbleiterschicht eine Bandlücke aufweist, die kleiner als die Bandlücke des elektrolumineszierenden Bereichs ist und einen Teil des Lichts absorbiert und Licht mit einer größeren Wellenlänge λ_{R} re-emittiert, der elektrolumineszierenden Bereich elektromagnetische Strahlung mit einer Wellenlänge von 780 nm aussendet, die erste Halbleiterschicht Licht einer zweiten, von der ersten Wellenlänge λ_{E} unterschiedlichen Wellenlänge λ_{R} re-emittiert, das von dem Halbleiterbauelement gemeinsam mit dem Licht der ersten Farbe emittiert wird.

In der WO97/50132 ist ein weißes Licht emittierendes Lumineszenzdioden-Bauelement beschrieben, bei dem auf einen blaues Licht emittierenden Lumineszenzdiodenchip beispielsweise eine YAG-Phosphor enthaltende Lumineszenz-Konversionsschicht aufgebracht ist. Die Lumineszenz-Konversionsschicht emittiert bei Anregung durch blaues Licht oder UV-Strahlung im gelben Spektralbereich. Für das Auge wird die Mischfarbe aus blauem Primär- und gelbem Sekundärlicht als Weiß wahrgenommen. Nachteilig ist hier der/die zusätzliche/n Prozeßschritt/e zum Herstellen der Lumineszenz-Konversionsschicht.

Die Aufgabe der vorliegenden Erfindung besteht darin, ein mischfarbiges Licht aussendendes Halbleiterbauelement zu entwickeln, dessen Herstellung einen geringen technischen Aufwand erfordert.

Diese Aufgabe wird im Wesentlichen durch ein Halbleiterbauelement mit den Merkmalen des Anspruches 1 gelöst.

Vorteilhafte Ausführungsformen und Weiterbildungen des Halbleiterbauelments sind Gegenstand der Unteransprüche 2 bis 6.

Bei einem Halbleiterbauelement der eingangs genannten Art weist demgemäß die erste Halbleiterschicht vorzugsweise ein Material auf, dessen Lage der Absorptionskante einer Wellenlänge λ_{abs} entspricht, die größer ist als die Wellenlänge λ_{E} der von der zweiten Halbleiterschicht emittierten Strahlung, und das bei Anregung mit Strahlung einer kleineren Wellenlänge als λ_{abs} Strahlung der Wellenlänger λ_{R} re-emittiert, die größer ist als λ_{abs}.

Bei einer bevorzugten Ausführungsform ist als erste Halbleiterschicht das Substrat zum epitaktischen Aufwachsen der zweiten Halbleiterschicht genutzt.

Bei einer Abwandlung ist sowohl die erste als auch die zweite Halbleiterschicht mittels Epitaxie auf einem Aufwachs-Substrat aufgebracht.

Eine vorteilhafte Ausführungsform weist auf, eine erste Halbleiterschicht (R), die ZnSe, und eine zweite Halbleiterschicht (E), die ein CdₓZn₁₋ₓSe/ZnSe-Quantentrogsystem (mit 0 ≤ x ≤ 1), insbesondere ein Mehrfachquantentrogsystem, als aktive Zone enthält.

Mit dem Begriff Halbleiterschicht ist hier nicht nur eine einzelne Schicht aus homogenem Halbleitermaterial gemeint, sondern kann auch ein Schichtsysteme oder eine Schichtenfolge aus mehreren verschiedenen Schichten und/oder graduierte Schichten gemeint sein.

Die Erfindung wird im Folgenden anhand von drei Abwandlungen in Verbindung mit den Figuren 1 bis 5 näher erläutert. Es zeigen:
Figur 1 einen ersten prinzipiellen Aufbau eines Lumineszenzdiodenchips
Figur 2 einen zweiten prinzipiellen Aufbau eines Lumineszenzdiodenchips
Figur 3 einen dritten prinzipiellen Aufbau eines Lumineszenzdiodenchips und
Figur 4 ein prinzipielles Wellenlängenspektrum eines erfindungsgemäßen Lumineszenzdiodenchips
Figur 5 ein prinzipielles Bänderschema eines erfindungsgemäßen Lumineszenzdiodenchips.

Im folgenden werden verschiedene Einzelaspekte eines erfindungsgemäßen Halbleiterbauelements, wie es in Anspruch 1 definiert wird, behandelt.

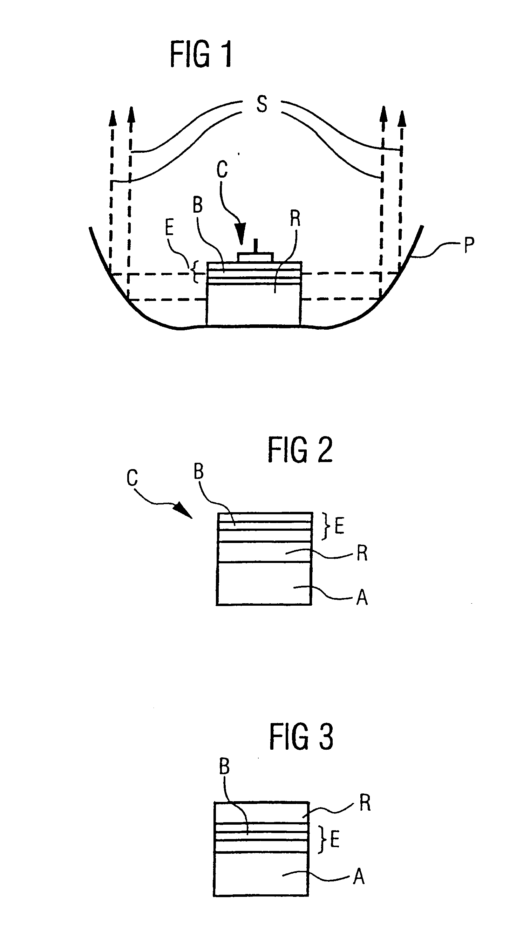

Bei dem prinzipiellen Aufbau eines Lumineszenzdiodenchips C in der Abwandlung gemäß Figur 1 ist auf einem Substrat R eine funktionelle Halbleiterschicht E aufgebracht.

In der Regel ist das Substrat R einkristallin und mittels Ziehen aus der Schmelze, Schneiden in dünne Scheiben und Polieren hergestellt.

Unter einer funktionellen Halbleiterschicht E, die im folgenden meist kurz mit Emissionsschicht E bezeichnet wird, ist eine Anordnung einer oder mehrerer Halbleiterschichten zu verstehen, die dazu dienen, bei Stromfluß durch den Chip in einem elekrolumineszierenden Bereich B elektromagnetische Strahlung zu erzeugen.

Das Substrat R ist mit einer Dicke von mehreren 100µm als stabile mechanische Unterlage etwa einen Faktor 100 dicker als eine auf diesem epitaktisch gewachsene Emissionsschicht E.

Eine typische funktionelle Halbleiterschicht E eines Lumineszenzdiodenchips besteht bekannterweise meist aus einer Mehrzahl von Halbleiterschichten unterschiedlicher Dicke, Zusammensetzung und Dotierung. Oft kommt als elektrolumineszierender Bereich B ein p-n-Übergang mit Quantenfilm(en) zum Einsatz. Die Dicke des Gesamtsystems liegt üblicherweise im µm-Bereich.

Um gezielte Änderungen der Eigenschaften durch gezielte Verunreinigungen (Dotierung) oder Beimischungen, sowie die Herstellung von atomar glatten Grenzflächen innerhalb der funktionellen Halbleiterschicht E zu erzielen ist diese beispielsweise mittels MBE (Molekularstrahlepitaxie) und/oder MOVPE (Metallorganische Dampfphasenepitaxie) hergestellt.

Bei der Abwandlung gemäß Figur 1 ist die Emissionswellenlänge λ_{E} der funktionellen Halbleiterschicht E kürzer als die Wellenlänge λ_{abs}, die der Absorptionskante des Substrates R entspricht.

Im Substrat R dominiert bei Raum- bzw. Betriebstemperatur die strahlende Rekombination bei der Wellenlänge λ_{R} (Re-Emissionswellenlänge) mit einer hohen Effektivität, wenn mit Strahlung kürzerer Wellenlänge als λ_{abs} angeregt wird. Die Bandlücke vom Substrat R ist demnach kleiner als die des emittierenden Überganges der Emissionsschicht E. Im Substrat R erfolgt im Betrieb des Lumineszenzdiodenchips eine Absorption zumindest eines Teiles der von der Emissionsschicht E in Richtung des Substrats R ausgesandten Strahlung. Es folgt eine Re-Emission vom Substrat R bei einer Re-Emissionswellenlänge λ_{R}, die größer ist als λ_{abs}, wobei hier Zustände in der Bandlücke des Substrates R beteiligt sind.

Damit ist ein kompakter Chip realisiert, der Strahlung S zweier deutlich unterschiedlicher Wellenlängen emittiert. Weil sich beide lichterzeugenden Volumina in unmittelbarer Nähe zueinander befinden, kann für das menschliche Auge der Eindruck von mischfarbigem Licht und im Spezialfall auch von weißem Licht entstehen. Dieser Effekt wird noch verstärkt, wenn sich der Lumineszenzdiodenchip, wie bei LEDs üblich und in Figur 1 schematisch dargestellt, in einem kleinen Parabolspiegel P befindet.

Die Abwandlung gemäß Figur 2 unterscheidet sich von der der Figur 1 im Wesentlichen dadurch, daß die Absorption und Re-Emission nicht im Aufwachs-Substrat A stattfindet, sondern daß hier eine separate Re-Emissionsschicht R vorgesehen ist, die zwischen dem Aufwachs-Substrat A und der Emissionsschicht E angeordnet ist und die dieselben Eigenschaften aufweist, wie das Substrat des Ausführungsbeispieles von Figur 1. Das Aufwachs-Substrat A ist hier entweder transparent oder absorbierend ausgebildet und dient hier ausschließlich als Aufwachs-Substrat.

Die Abwandlung gemäß Figur 3 ist im Wesentlichen identisch zu der der Figur 2, bis auf den Unterschied, daß hier die Re-Emissionsschicht R nicht zwischen dem Aufwachs-Substrat A und der funktionellen Halbleiterschicht B, sondern auf der dem Aufwachs-Substrat A gegenüberliegenden Seite der Emissionsschicht E angeordnet ist.

Durch Variation z. B. der Quantentrogdicke in einer funktionellen Halbleiterschicht E mit Quantentrogstruktur oder der Zusammensetzung(en) in der funktionellen Halbleiterschicht E kann die Emissionswellenlänge λ_{E} in gewissen Grenzen eingestellt werden, wobei die Bedingung λ_{E}<λ_{abs} zu beachten ist. Die Lage der Absorptionskante des Substrats bzw. der Re-Emissionsschicht R ist durch die Wahl des Substrat- bzw. Re-Emissionsschicht-Materials bestimmt. Die Re-Emissionswellenlänge λ_{R} (relativ zur Absorptionskante A) hängt von der Art der Erzeugung der Zustände der Bandlücke ab.

Das Verhältnis (Intensität der vom Substrat R bzw. Re-Emissionsschicht R emittierten Strahlung)/(Intensität der von der funktionellen Halbleiterschicht E emittierten Strahlung) kann gezielt beeinflußt werden durch:
a) die Dicke des Substrates bzw. der Re-Emissionsschicht R und damit des absorptiven und re-emittierenden Volumens (dies kann z. B. durch Abdünnen erreicht werden);
b) die Rate der strahlenden Rekombination im Substrat bzw.
   der Re-Emissionsschicht R (dies kann durch gezielte Einbringung von (nicht) strahlenden Rekombinationskanälen erfolgen);
c) die Effektivität des Wellenleiters (extrem helle LEDs sind als sogenannte Doppelheterostrukturen aufgebaut; dabei erreicht man einen wellenleitenden Effekt senkrecht zur Wachstumsrichtung durch entsprechende Brechzahlsprünge der Schichten; je besser diese Wellenführung, desto weniger Photonen werden überhaupt in das Substrat bzw. in die Re-Emissionsschicht R gelangen und desto größer wird ihr Anteil im Vergleich zu der vom Substrat bzw. von der Re-Emissionsschicht R emittierten Strahlung); und
d) die Lage der Emissionswellenlänge λ_{E} relativ zur Absorptionskante des Substrates bzw. der Re-Emissionsschicht R (je näher die Emissionswellenlänge λ_{E} an der Absorptionskante des Substrates bzw. der Re-Emissionsschicht R liegt, desto transparenter wird das Substrat bzw. die Re-Emissionsschicht R und desto geringer wird die Absorption/Re-Emission dort. Um den Subtrat- bzw. Re-Emissionsschicht-Anteil geringer zu halten, kann es auch notwendig sein, von der Bedingung λ_{E}<λ_{abs} abzuweichen, wenn auch noch für λ_{E}>λ_{abs} genügend Absorption stattfindet).

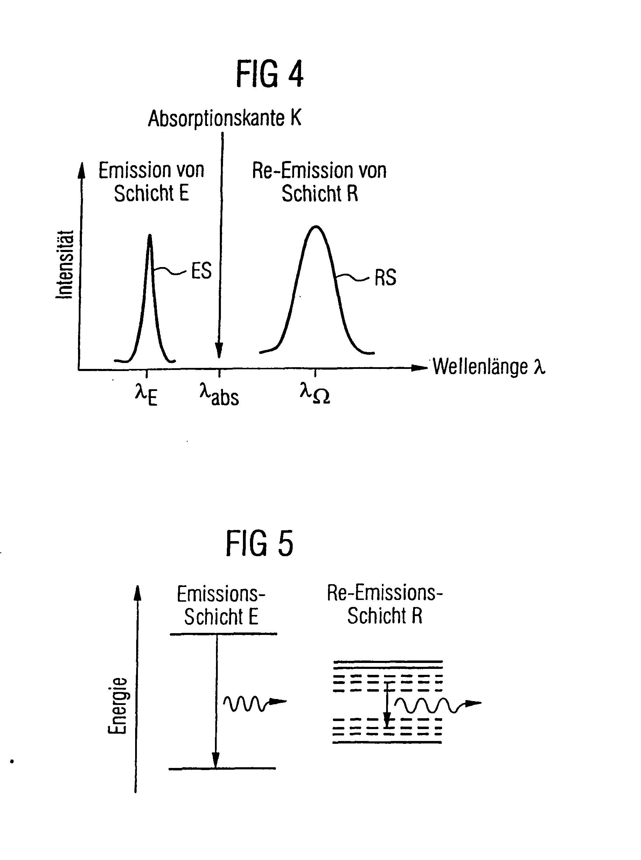

Bei dem in Figur 4 dargestellten Wellenlängenspektrum ist auf der Abszisse die Wellenlänge λ und auf der Ordinate die Intensität jeweils ohne Skalierung aufgetragen. Das Emissionsspektrum ES der Emissionsschicht E mit einer Peak-Wellenlänge λ_{E} befindet sich bei kürzeren Wellenlängen als das Re-Emissionsspektrum RS der Re-Emissionsschicht R mit einer Peak-Wellenlänge λ_{R}. Bei einer Wellenlänge λ_{abs} zwischen dem Emissionsspektrum ES und dem Re-Emissionsspektrum RS liegt die Absorptionskante K der Re-Emissionsschicht R.

Bei dem Bänderschema von Figur 5 ist die Energie senkrecht aufgetragen. Der linke Teil zeigt die Bandlücke der Emissionsschicht E; der senkrechte und der schlangenförmige Pfeil deutet einen strahlenden Übergang in der Emissionsschicht an. Der rechte Teil des Bänderschemas zeigt die Bandlücke der Re-Emissionsschicht R mit Zuständen in der Bandlücke. Der senkrechte und der schlangenförmige Pfeil deuten wiederum einen strahlenden Übergang in der Re-Emissionsschicht an. Die Re-Emission in der Re-Emissionsschicht R wird durch die von der Emissionsschicht E ausgesandte Strahlung angeregt.

Ein bevorzugtes Materialsystem für die Herstellung eines derartigen Halbleiterchips ist beispielsweise eine zweite Halbleiterschicht E, die CdₓZn₁₋ₓSe/ZnSe (mit 0 ≤ x ≤ 1) enthält, auf einem ZnSe-Substrat als erste Halbleiterschicht R.

ZnSe besitzt bei Raumtemperatur eine Bandlücke von 2,7eV, was einer Wellenlänge von 460 nm entspricht. Bei vielen Züchtungsmethoden von Volumenmaterial führen die hohen Temperaturen oder die mangelnde Reinheit der Ausgangsmaterialien dazu, daß Verunreinigungen unabsichtlich in die Kristalle eingebaut werden, die dann zu Zuständen in der Bandlücke führen können. Eine besonders starke Raumtemperatur-Lumineszenz um 600 nm zeigen leitfähige ZnSe-Substrate, wie sie zum Beispiel durch nachträgliches Tempern in Zinkdampf oder durch Dotierung mit Aluminium erzeugt werden können.

Als zweite Halbleiterschicht E eignet sich in diesem Fall beispielsweise eine einfache ZnSe-p-n-Diode mit einem (Cd,Zn)Se/ZnSe-Mehrfachquantentrogsystem als aktive Zone (elektrolumineszierender Bereich B). Je nach Cadmiumgehalt kann die Wellenlänger λ_{E} der von einer derartigen aktiven Zone emittierten Strahlung vom Blauen (460 nm) bis ins Grüne (540 nm) verschoben werden.

Die Absorptionskante λ_{abs} des Substrates ist durch einen höhen Jodgehalt zu etwa 515 nm hin verschoben. Damit sind alle Voraussetzungen für ein Halbleiterbauelment gemäß dem Ausführungsbeispiel von Figur 1 erfüllt, wenn zum Beispiel eine Lumineszenzdiodenstruktur mit 489 nm und/oder 508 nm Emissionswellenlänge auf dem Substrat aufgebracht ist.

Als Substrat wird bevorzugt ein ZnSe:I-Substrat verwendet, das mittels Bridgeman-Züchtung hergestellt ist. Weitere mögliche Substrat-Züchtungsmethoden sind die Jodtransport-Züchtung und die Sublimationszüchtung.

Das oben beschriebene Substrat muß nicht unbedingt als Substrat während des Wachstumsprozesses der Schichten gedient haben. Vielmehr kann ein Kontakt von Schicht und Absorptions/Re-Emissions-Substrat auch erst im Nachhinein zum Beispiel durch Wafer-Bonding hergestellt werden.

Die gewünschte Mischfarbe kann durch geeignete Wahl der emittierenden Schicht (zweite Halbleiterschicht E) und des Substrats (erste Halbleiterschicht R) erreicht werden.

## Patentansprüche

1. Halbleiterbauelement, das einen Halbleiterchip (C) mit einer ersten Halbleiterschicht (R) und einer benachbart zu dieser angeordneten zweiten Halbleiterschicht (E) aufweist, die auf einem Substrat (A) aufgebracht ist, wobei die erste Halbleiterschicht (R) zwischen dem Substrat (A) und der zweiten Halbleiterschicht (E) angeordnet ist oder die erste Halbleiterschicht auf der dem Substrat gegenüber liegenden Seite der zweiten Halbleiterschicht angeordnet ist,
die zweite Halbleiterschicht (E) einen elektrolumineszierenden Bereich (B) enthält, der Licht mit einer Wellenlänge λ_{E} aussendet, und
die erste Halbleiterschicht (R) eine Bandlücke aufweist, die kleiner als die Bandlücke des elektrolumineszierenden Bereichs (B) ist und einen Teil des Lichts absorbiert und Licht mit einer größeren Wellenlänger λ_{R} re-emittiert,
der elektrolumineszierende Bereich (B) sichtbares Licht einer ersten Farbe mit der Wellenlänge λ_{E} aussendet,
die erste Halbleiterschicht (R) sichtbares Licht einer zweiten, von der ersten unterschiedlichen Farbe mit der Wellenlänge λ_{R} re-emittiert, das von dem Halbleiterbauelement gemeinsam mit dem Licht der ersten Farbe emittiert wird, und das Halbleiterbauelement ein Halbleiterbauelement zur Erzeugung mischfarbigen Lichts (S) ist,
wobei die erste Halbleiterschicht (R) Zustände innerhalb der Bandlücke aufweist, die bei der Re-Emission beteiligt sind, wobei die Zustände innerhalb der Bandlücke gezielt eingebracht sind, wodurch das Verhältnis zwischen der Intensität der von der ersten Halbleiterschicht (R) emittierten Strahlung zu der von der zweiten Halbleiterschicht (E) emittierten Strahlung eingestellt wird wobei ein Kontakt von erster Halbleiterschicht (R) oder zweiter Halbleiterschicht (E) und Substrat (A) durch Wafer-bonding hergestellt ist.

2. Halbleiterbauelement gemäß Anspruch 1,
**dadurch gekennzeichnet, dass** die erste Halbleiterschicht (R) ein Material aufweist, das eine Absorptionskante besitzt, deren Energieniveau einer Wellenlänge λ_{abs} entspricht, die größer ist als die Wellenlänge λ_{E} der von der zweiten Halbleiterschicht (E) emittierten Strahlung, und das bei Anregung mit Strahlung einer kleineren Wellenlänge als λ_{abs} Strahlung der Wellenlänge λ_{R} re-emittiert, die größer als λ_{abs} ist.

3. Halbleiterbauelement nach einem der Ansprüche 1 bis 2, **dadurch gekennzeichnet, dass** die erste Halbleiterschicht (R) dotiertes ZnSe und die zweite Halbleiterschicht (E) eine aktive Zone aufweist, die CdₓZn₁₋ₓSe/ZnSe (mit 0 ≤ x ≤ 1) enthält.

4. Halbleiterbauelement nach einem der Ansprüche 1 bis 3, **dadurch gekennzeichnet, dass** sich der Halbleiterchip (C) in einem Parabolspiegel befindet.

5. Halbleiterbauelement nach einem der Ansprüche 1 bis 4, **dadurch gekennzeichnet, dass** das Substrat (A) von einem Aufwachs-Substrat verschieden ist.

6. Halbleiterbauelement nach einem der Ansprüche 1 bis 5, **dadurch gekennzeichnet, dass** das mischfarbige Licht weißes Licht ist.

## Claims

1. Semiconductor component comprising a semiconductor chip (C) having a first semiconductor layer (R) and a second semiconductor layer (E), which is arranged adjacent to said first semiconductor layer and is applied on a substrate (A), wherein the first semiconductor layer (R) is arranged between the substrate (A) and the second semiconductor layer (E) or the first semiconductor layer is arranged on the opposite side of the second semiconductor layer relative to the substrate,
the second semiconductor layer (E) contains an electroluminescent region (B) which emits light having a wavelength λ_{E}, and
the first semiconductor layer (R) has a band gap which is smaller than the band gap of the electroluminescent region (B) and absorbs part of the light and re-emits light having a longer wavelength λ_{R},
the electroluminescent region (B) emits visible light of a first colour having the wavelength λ_{E}, the first semiconductor layer (R) re-emits visible light of a second colour, different from the first, having the wavelength λ_{R}, which light is emitted by the semiconductor component together with the light of the first colour, and the semiconductor component is a semiconductor component for generating mixed-coloured light (S),
wherein
the first semiconductor layer (R) has states within the band gap which participate in the re-emission, wherein the states within the band gap are introduced in a targeted manner, as a result of which the ratio between the intensity of the radiation emitted by the first semiconductor layer (R) and the radiation emitted by the second semiconductor layer (E) is set, wherein a contact of first semiconductor layer (R) or second semiconductor layer (E) and substrate (A) is produced by wafer bonding.

2. Semiconductor component according to Claim 1, **characterized in that**
the first semiconductor layer (R) comprises a material which has an absorption edge whose energy level corresponds to a wavelength λ_{abs} longer than the wavelength λ_{E} of the radiation emitted by the second semiconductor layer (E), and which, upon excitation with radiation having a wavelength shorter than λ_{abs}, re-emits radiation having the wavelength λ_{R}, which is longer than λ_{abs}.

3. Semiconductor component according to either of Claims 1 and 2,
**characterized in that**
the first semiconductor layer (R) comprises doped ZnSe and the second semiconductor layer (E) has an active zone containing CdₓZn₁₋ₓSe/ZnSe (where 0 ≤ x ≤ 1).

4. Semiconductor component according to any of Claims 1 to 3,
**characterized in that**
the semiconductor chip (C) is situated in a parabolic mirror.

5. Semiconductor component according to any of Claims 1 to 4,
**characterized in that**
the substrate (A) is different from a growth substrate.

6. Semiconductor component according to any of Claims 1 to 5,
**characterized in that**
the mixed-coloured light is white light.

## Revendications

1. Composant semi-conducteur présentant une puce semi-conductrice (C) dotée d'une première couche semi-conductrice (R) et d'une deuxième couche semi-conductrice (E) disposée au voisinage de la première et appliquée sur un substrat (A),
la première couche semi-conductrice (R) étant disposée entre le substrat (A) et la deuxième couche semi-conductrice (E) ou la première couche semi-conductrice étant disposées sur le côté de la deuxième couche semi-conductrice situé face au substrat,
la deuxième couche semi-conductrice (E) contenant une partie électroluminescente (B) qui émet de la lumière d'une longueur d'onde λ_{E},
la première couche semi-conductrice (R) présentant un interstice de bande plus petit que l'interstice de bande de la partie électroluminescente (B) et qui absorbe une partie de la lumière et réémet de la lumière d'une plus grande longueur d'onde λ_{R},
la partie électroluminescente (B) émettant de la lumière visible d'une première couleur d'une longueur d'onde λ_{E},
la première couche semi-conductrice (R) réémettant de la lumière visible d'une deuxième longueur d'onde λ_{R} d'une couleur différente de la première et qui est émise par le composant semi-conducteur en même temps que la lumière de la première couleur, l'élément semi-conducteur étant un composant semi-conducteur destiné à former de la lumière (S) de couleurs mélangées,
la première couche semi-conductrice (R) présentant à l'intérieur de l'interstice de bande des états qui participent à la réémission, les états étant formés de manière contrôlée à l'intérieur de l'interstice de bande de telle sorte que le rapport entre l'intensité du rayonnement émis par la première couche semi-conductrice (R) par rapport à celle du rayonnement émis par la deuxième couche semi-conductrice (E) puisse être ajusté,
le contact entre la première couche semi-conductrice (R) ou la deuxième couche semi-conductrice (E) et le substrat (A) étant formé par liaison de tranches.

2. Composant semi-conducteur selon la revendication 1, **caractérisé en ce que** la première couche semi-conductrice (R) présente un matériau qui possède un bord d'absorption dont le niveau d'énergie correspond à une longueur d'onde λ_{abs} supérieure à la longueur d'onde λ_{E} du rayonnement émis par la deuxième couche semi-conductrice (E) et réémet lors d'une excitation par un rayonnement d'une plus petite longueur d'onde que λ_{abs} un rayonnement de longueur d'onde λ_{R} supérieur à λ_{abs}.

3. Composant semi-conducteur selon l'une des revendications 1 et 2, **caractérisé en ce que** la première couche semi-conductrice (R) contient du ZnSe dopé et la deuxième couche semi-conductrice (E) présente une zone active qui contient du CdₓZn₁₋ₓSe/ZnSe (avec 0 ≤ x ≤ 1).

4. Composant semi-conducteur selon l'une des revendications 1 à 3, **caractérisé en ce que** la puce semi-conductrice (C) est placée dans un miroir parabolique.

5. Composant semi-conducteur selon l'une des revendications 1 à 4, **caractérisé en ce que** le substrat (A) est différent d'un substrat obtenu par croissance épitaxique.

6. Composant semi-conducteur selon l'une des revendications 1 à 5, **caractérisé en ce que** la lumière de couleurs mélangées est de la lumière blanche.
